(19) Europäisches Patentamt
European Patent Office
Office européen des brevets

(11) **EP 4 411 783 A1**

(12) **EUROPEAN PATENT APPLICATION**

(43) Date of publication:
**07.08.2024 Bulletin 2024/32**

(51) International Patent Classification (IPC):
***H01J 37/28*** *(2006.01)* ***G03H 5/00*** *(2006.01)*

(21) Application number: **23154317.4**

(52) Cooperative Patent Classification (CPC):
**H01J 37/28;** H01J 2237/228; H01J 2237/2614

(22) Date of filing: **31.01.2023**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **ASML Netherlands B.V.
5500 AH Veldhoven (NL)**

(72) Inventor: **VAN RENS, Jasper, Frans, Mathijs
5500 AH Veldhoven (NL)**

(74) Representative: **ASML Netherlands B.V.
Corporate Intellectual Property
P.O. Box 324
5500 AH Veldhoven (NL)**

(54) **LEEM BASED HOLOGRAPHY**

(57) A particle beam system comprising a beam splitter 340,342 configured to split a particle beam 330 into a first particle beam 334 and a second particle beam 332, the first and second particle beams being coherent along at least a portion of their path lengths; a reference line 338 configured to enable transmission of the first particle beam; a sample line 336 configured to enable the second particle beam to interact with a sample 360; a delay segment configured to alter 366 a path length of the first particle beam in the reference line and/or to alter 364 a path length of the second particle beam in the sample line; and a beam combiner 344 configured to recombine a) the first particle beam after the reference line, and b) the second particle beam after the sample line, wherein the recombination of the first and second particle beams causes interference between the first and the particle beams. The system optionally comprises a sensor 380 configured to detect intensity of the interference between the first particle beam and the second particle beam.

FIG. 3

**Description**

<u>TECHNICAL FIELD</u>

The present disclosure relates generally to a system and method for scanning electron microscopy (SEM) holography.

<u>BACKGROUND</u>

In manufacturing processes of integrated circuits (ICs), unfinished or finished circuit components are inspected to ensure that they are manufactured according to design and are free of defects. Inspection systems utilizing optical microscopes or charged particle (e.g., electron) beam microscopes, such as a scanning electron microscope (SEM) can be employed. As the physical sizes of IC components continue to shrink, and their structures continue to become more complex, accuracy and throughput in defect detection and inspection become more important. Imaging of complex structures such as high-aspect-ratio trenches or holes of 3D NAND devices, thick resists which may have low contrast, etc. may require imaging of 3D features which have projections in the electron beam direction which are larger than a focal length of a traditional SEM. For applications such as overlay metrology, defect inspection (including resist inspection, etch inspection), etc., it may be desirable to obtain high quality imaging with information about surface profiles from reflected electrons.

In the context of semiconductor manufacture, wafers need to be monitored and defects identified, preferably at stages where they may be corrected. Various solutions for imaging have been proposed.

<u>SUMMARY</u>

According to an embodiment, there is provided a particle beam system. The particle beam system comprises a beam splitter configured to split a particle beam into a first particle beam and a second particle beam. The first particle beam and the second particle beam are coherent along at least a portion of their path lengths. The particle beam system comprises a reference line configured to enable transmission of the first particle beam and a sample line configured to enable the second particle beam to interact with a sample. The particle beam system comprises a delay segment configured to alter a path length of the first particle beam in the reference line and/or to alter a path length of the second particle beam in the sample line. The particle beam system comprises a beam combiner configured to recombine a) the first particle beam after it passes through the reference line, and b) the second particle beam after it passes through the sample line. The recombination of the first particle beam and the second particle beam causes interference between the first particle beam and the second particle beam.

In an embodiment, the sample line comprises a low-energy electron microscopy (LEEM) arrangement.

In an embodiment, the second particle beam is elastically scattered by the sample.

In an embodiment, the delay segment comprises a particle mirror.

In an embodiment, the sample line and/or the reference line comprises a magnetic prism.

In an embodiment, the particle beam system further comprises a sensor to detect the recombination, where the sensor is configured to detect intensity of the interference between the first particle beam and the second particle beam.

In an embodiment, the particle beam system further comprises a processor, and one or more non-transitory, machine-readable medium having instructions thereon. The instructions when executed by the processor are configured to determine phase and/or amplitude of a waveform of the first particle beam after it has interacted with the sample based on the interference between the first particle beam and the second particle beam.

In an embodiment, the instructions further comprise instructions to reconstruct a depth profile of the sample based on the determined phase and/or amplitude of the waveform of the first particle beam after it has interacted with the sample.

In an embodiment, the instructions further comprise instructions to apply an aberration correction to the determined phase and/or amplitude of the waveform of the first particle beam after it has interacted with the sample.

In an embodiment, the instructions further comprise instructions to determine an aberration correction.

In an embodiment, where the instructions to determine an aberration correction are based on a recombination of the first particle beam and the second particle beam obtained when the second particle beam has not interacted with a sample and/or when the particle beam has interacted with a known sample.

In an embodiment, the delay segment is further configured to alter the path length of the first particle beam and/or to alter the path length of the second particle beam such that the first particle beam and the second particle beam interfere at their recombination.

In an embodiment, the beam splitter is a biprism and wherein the beam combiner is a biprism.

According to an embodiment, a delay line for a particle beam system, wherein the delay line is configured to alter a path length of at least a portion of a particle beam of the particle beam system.

According to an embodiment, a particle beam system comprising a sample line configured to enable a particle beam to interact with a sample is provided. The particle beam system comprises a phase modulator, where the phase modulator is configured to output a first portion of the particle beam with a first phase and a second portion of the particle beam with a second phase. The particle beam system comprises a sensor, where the sensor is configured to detect a recombination of the first portion and the second portion of the particle beam.

In an embodiment, the recombination of the first portion and the second portion of the particle beam comprises interference of the first portion of the particle beam and the second portion of the particle beam.

In an embodiment, the phase modulator comprises a Zernike phase plate and wherein the first portion of the particle beam comprise a diffracted portion of the particle beam and wherein the second portion of the particle beam comprises an undiffracted portion of the particle beam.

According to an embodiment, a method for particle beam microscopy is provided. The method comprising splitting, by a beam splitter, a particle beam into a first particle beam and a second particle beam, the first particle beam and the second particle beam being coherent along at least a portion of their path lengths, transmitting the first particle beam along a reference line, transmitting a second particle beam along a sample line, the sample line configured to enable interaction of the second particle beam with a sample, wherein the reference line and/or the sample line further comprise a delay segment, the delay segment configured to alter a path length of the first particle beam and/or to alter a path length of the second particle beam, and recombining, by a beam combiner, a) the first particle beam after it passes through the reference line and b) the second particle beam after it passes through the sample line, wherein the recombination of the first particle beam and the second particle beam causes interference between the first particle beam and the second particle beam.

In an embodiment, the method further comprises applying an aberration correction to the recombination.

In an embodiment, the method further comprises determining the aberration correction. Determining the aberration correction comprises transmitting the first particle beam along the reference line, the delay segment configured to alter the path length of the first particle beam to correspond to the path length of the second particle beam and/or to alter the path length of the second particle beam to correspond to the path length of the first particle beam, transmitting a second particle beam along the sample line, the sample line configured to enable reflection of the second particle beam from a null sample and/or a known sample, recombining, by the beam combiner, a) the first particle beam after it passes through the reference line and b) the second particle beam after it has been reflected by the null sample and/or after it has been reflected by the known sample to generate an aberration-correction recombination, and determining an aberration correction based on the aberration-correction recombination.

In an embodiment, the method further comprises determining phase and/or amplitude of a waveform of the first particle beam after it has interacted with the sample based on the recombination.

In an embodiment, the method further comprises reconstructing a depth profile of the sample based on the recombination.

According to an embodiment, an apparatus configured to perform the method of any other embodiment is provided.

According to another embodiment, one or more non-transitory, machine-readable medium is provided having instructions thereon, the instructions when executed by a processor being configured to perform the method of any other embodiment.

BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:

Figure 1 is a schematic diagram illustrating an exemplary particle beam system, according to an embodiment.
Figure 2 is a schematic diagram of an exemplary particle beam tool, according to an embodiment.
Figure 3 is a schematic diagram of an exemplary particle beam tool configured for holography based on a sample line and a reference line, according to an embodiment.
Figure 4 is a schematic diagram of an exemplary particle beam tool configured for holography based on a phase modulator, according to an embodiment.
Figure 5 is a schematic diagram of an exemplary particle beam tool delay line, according to an embodiment.
Figure 6 is a flowchart that illustrates a method of particle beam holography, according to an embodiment.
Figure 7 is a schematic diagram of an exemplary recombination of a first particle beam and a second particle beam, according to an embodiment.

Figure 8 is a schematic diagram of an exemplary aberration correction, according to an embodiment.
Figure 9 is a block diagram of an example computer system, according to an embodiment of the present disclosure.

DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion", respectively. A patterning device (for example, a lithography device) can comprise, or can form, one or more patterns, which may correspond to one or die. The patterns can be generated utilizing CAD (computer-aided design) programs, based on a pattern or design layout, this process often being referred to as EDA (electronic design automation).

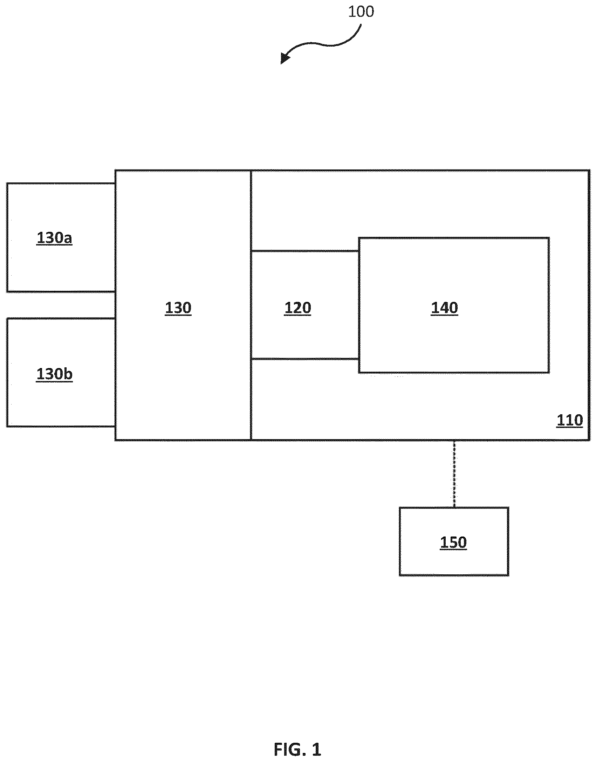

Reference is now made to Figure 1, which illustrates an exemplary electron beam system 100 consistent with embodiments of the present disclosure. As shown in Figure 1, the electron beam system 100 includes a main chamber 110, a load-lock chamber 120, an electron beam tool 140, and an equipment front end module (EFEM) 130. Electron beam tool 140 is located within main chamber 110. The exemplary electron beam system 100 may be a single or multi-beam system. While the description and drawings are directed to an electron beam, it should be appreciated that the embodiments of the present disclosure are not limited to specific particles. Electrons may instead or additionally include other charged particles, such as ions, protons, etc.

EFEM 130 includes a first loading port 130a and a second loading port 130b. EFEM 130 may include additional loading port(s). First loading port 130a and second loading port 130b may receive wafer front opening unified pods (FOUPs) that contain wafers (e.g., semiconductor wafers or wafers made of other material(s)) or samples to be inspected (wafers and samples are collectively referred to as "wafers" hereafter). One or more robot arms (not shown) in EFEM 130 transport the wafers to load-lock chamber 120.

Load-lock chamber 120 is connected to a load/lock vacuum pump system (not shown), which removes gas molecules in load-lock chamber 120 to reach a first pressure below the atmospheric pressure. After reaching the first pressure, one or more robot arms (not shown) transport the wafer from load-lock chamber 120 to main chamber 110. Main chamber 110 is connected to a main chamber vacuum pump system (not shown), which removes gas molecules in main chamber 110 to reach a second pressure below the first pressure. After reaching the second pressure, the wafer is subject to inspection by electron beam tool 140. In some embodiments, the electron beam tool 140 may comprise a single-beam inspection tool. In some embodiments, the electron beam tool 140 may comprise a multi-beam inspection tool.

Controller 150 may be electronically connected to electron beam tool 140 and may be electronically connected to other components as well. Controller 150 may be a computer configured to execute various controls of electron beam system 100. Controller 150 may also include processing circuitry configured to execute various signal and image processing functions. While controller 150 is shown in Figure 1 as being outside of the structure that includes main chamber 110, load-lock chamber 120, and EFEM 130, it is appreciated that controller 150 can be part of the structure.

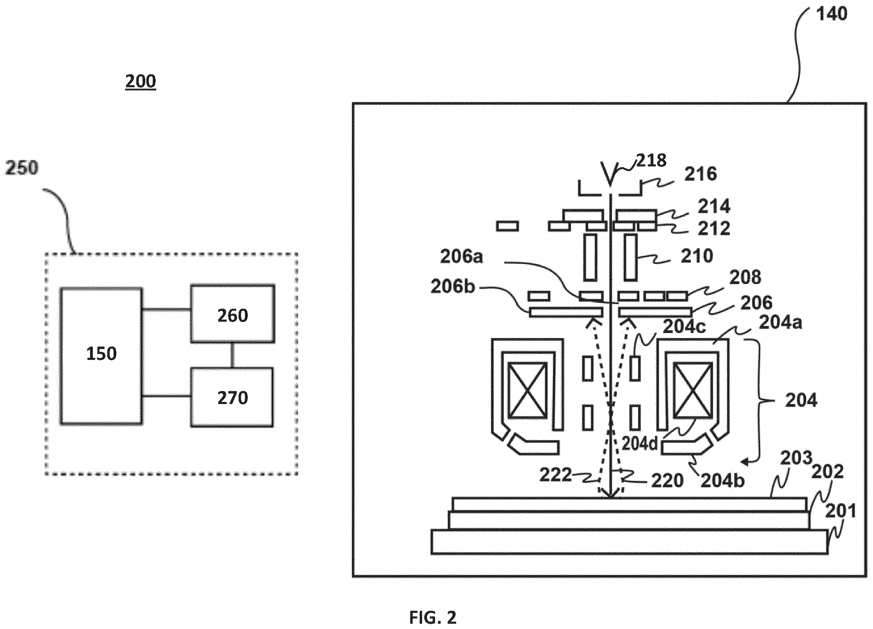

FIG. 2 illustrates schematic diagram of an exemplary imaging system 200 according to embodiments of the present disclosure. Electron beam tool 140 of FIG. 2 may be configured for use in electron beam system 100. Electron beam tool 140 may be a single beam apparatus or a multi-beam apparatus. As shown in FIG. 2, electron beam tool 140 includes a motorized sample stage 201, and a wafer holder 202 supported by motorized sample stage 201 to hold a wafer 203 to be inspected. Electron beam tool 140 further includes an objective lens assembly 204, an electron detector 206 (which includes electron sensor surfaces 206a and 206b), an objective aperture 208, a condenser lens 210, a beam limit aperture 212, a gun aperture 214, an anode 216, and a cathode. The electron detector 206 may be a single electron detector, multiple electron detectors, contain multiple electron detector elements, etc. In one embodiment, the electron detector 206 may be an electron detector for the electron beam tool 140, which is a multi-beam tool, a parallel beam tool, a massively parallel beam tool, etc. The electron detector 206 may have one or more apertures, such as to allow penetration of one or more electron beam (such as in a forward direction from the cathode 218 to the motorized sample stage 201). The electron detector 206 may have multiple apertures, such as apparatus which correspond to one or more of multiple electron beams. Objective lens assembly 204, in some embodiments, may include a modified swing objective retarding immersion lens (SORIL), which includes a pole piece 204a, a control electrode 204b, a deflector 204c, and an exciting coil 204d. Electron beam tool 140 may additionally include an Energy Dispersive X-ray Spectrometer (EDS) detector (not shown) to characterize the materials on wafer 203.

A primary electron beam 220 is emitted from cathode 218 by applying a voltage between anode 216 and cathode 218. Primary electron beam 220 passes through gun aperture 214 and beam limit aperture 212, both of which may determine the size of electron beam entering condenser lens 210, which resides below beam limit aperture 212. Condenser lens 210 focuses primary electron beam 220 before the beam enters objective aperture 208 to set the size of the electron beam before entering objective lens assembly 204. Deflector 204c deflects primary electron beam 220 to facilitate beam scanning on the wafer. For example, in a scanning process, deflector 204c may be controlled to deflect primary electron beam 220 sequentially onto different locations of top surface of wafer 203 at different time points, to provide data for image reconstruction for different parts of wafer 203. Moreover, deflector 204c may also be controlled to deflect primary electron beam 220 onto different sides of wafer 203 at a particular location, at different time points, to provide data for stereo image reconstruction of the wafer structure at that location. Further, in some embodiments, anode 216 and cathode 218 may be configured to generate multiple primary electron beams 220, and electron beam tool 140 may include a plurality of deflectors 204c to project the multiple primary electron beams 220 to different parts/sides of the wafer at the same time, to provide data for image reconstruction for different parts of wafer 203.

Exciting coil 204d and pole piece 204a generate a magnetic field that begins at one end of pole piece 204a and terminates at the other end of pole piece 204a. A part of wafer 203 being scanned by primary electron beam 220 may be immersed in the magnetic field and may be electrically charged, which, in turn, creates an electric field. The electric field reduces the energy of impinging primary electron beam 220 near the surface of wafer 203 before it collides with wafer 203. Control electrode 204b, being electrically isolated from pole piece 204a, controls an electric field on wafer 203 to prevent micro-arching of wafer 203 and to ensure proper beam focus.

A secondary electron beam 222 may be emitted from the part of wafer 203 upon receiving primary electron beam 220. Secondary electron beam 222 may form a beam spot on electron sensor surfaces 206a and 206b of electron detector 206. Electron detector 206 may generate a signal (e.g., a voltage, a current, etc.) that represents an intensity of the beam spot, and provide the signal to an image processing system 250. The intensity of secondary electron beam 222, and the resultant beam spot, may vary according to the external or internal structure of wafer 203. Moreover, as discussed above, primary electron beam 220 may be projected onto different locations of the top surface of the wafer or different sides of the wafer at a particular location, to generate secondary electron beams 222 (and the resultant beam spot) of different intensities. Therefore, by mapping the intensities of the beam spots with the locations of wafer 203, the processing system may reconstruct an image that reflects the internal or surface structures of wafer 203.

Imaging system 200 may be used for inspecting a wafer 203 on motorized sample stage 201, and comprises an electron beam tool 140, as discussed above. Imaging system 200 may also comprise an image processing system 250 that includes an image acquirer 260, storage 270, and controller 150 (which may be the controller 150 of Figure 1). Image acquirer 260 may comprise one or more processors. For example, image acquirer 260 may comprise a computer, server, mainframe host, terminals, personal computer, any kind of mobile computing devices, and the like, or a combination thereof. Image acquirer 260 may connect with an electron detector 206 of electron beam tool 140 through a medium such as an electrical conductor, optical fiber cable, portable storage media, IR, Bluetooth, internet, wireless network, wireless radio, or a combination thereof. Image acquirer 260 may receive a signal from electron detector 206 and may construct an image. Image acquirer 260 may thus acquire images of wafer 203. Image acquirer 260 may also perform various post-processing functions, such as generating contours, superimposing indicators on an acquired image, and the like. Image acquirer 260 may be configured to perform adjustments of brightness and contrast, etc. of acquired images. Storage 270 may be a storage medium such as a hard disk, cloud storage, random access memory (RAM), other types of computer readable memory, and the like. Storage 270 may be coupled with image acquirer 260 and may be used for saving scanned raw image data as original images, and post-processed images. Image acquirer 260 and storage 270 may be connected to controller 150. In some embodiments, image acquirer 260, storage 270, and controller 150 may be integrated together as one control unit.

In some embodiments, image acquirer 260 may acquire one or more images of a sample based on an imaging signal received from electron detector 206. An imaging signal may correspond to a scanning operation for conducting charged electron imaging. An acquired image may be a single image comprising a plurality of imaging areas. The single image may be stored in storage 270. The single image may be an original image that may be divided into a plurality of regions. Each of the regions may comprise one imaging area containing a feature of wafer 203.

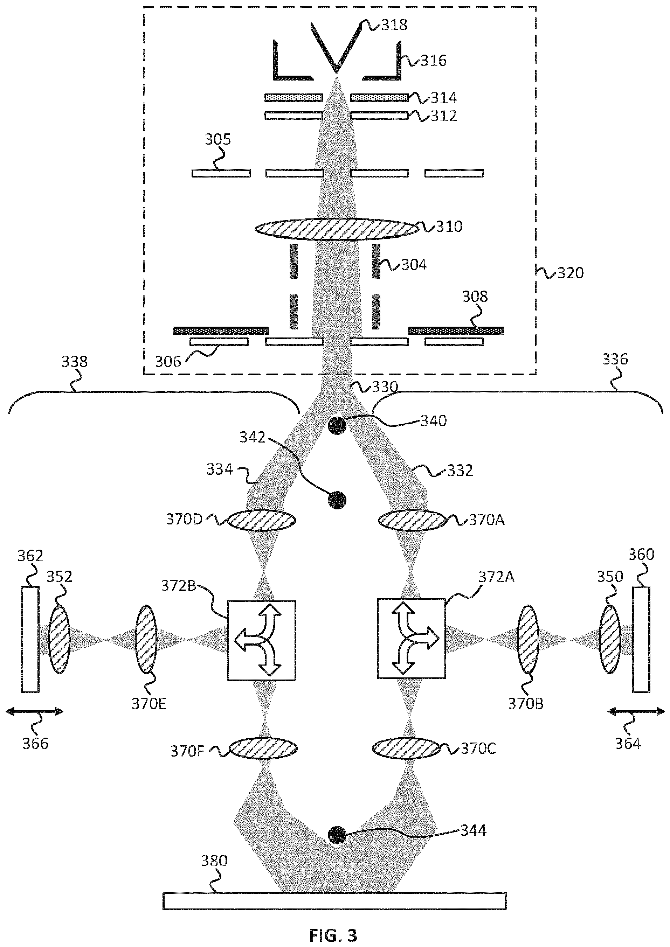

Figure 3 is a schematic diagram of an exemplary particle beam tool configured for holography based on a sample line and a reference line. Figure 3 is a plan view of an exemplary particle beam apparatus comprising an electron beam source 320, which may be any appropriate electron beam source, such as that of the electron beam tool 140 of Figure 2. The electron beam source 320 is depicted as having a cathode 318, an anode 316, a gun aperture 314, a beam limit aperture 312, a condenser lens 310, an objective lens 305, an objective lens assembly 304, an objective aperture 308, and an electron detector 306. The electron beam source 320 may have more or fewer components, including multiple of the components (e.g., the cathode 318, the anode 316, the gun aperture 314, the beam limit aperture 312, the condenser lens 310, the objective lens 305, the objective lens assembly 304, the objective aperture 308, and the electron detector 306) depicted. The components may be integrated into one or more components, such that components depicted as separate elements may be instead integrated elements. The components may be any appropriate components, such as those described with reference to Figure 2.

The electron beam source 320 emits an electron beam 330, which is a coherent electron beam. The electron beam 330 is split by a beam splitter 240 into a sample electron beam 332 and a reference electron beam 334. The sample electron beam 332 and the reference electron beam 334 are coherent. The sample electron beam 332 and the reference electron beam 334 may have the same characteristics as the electron beam 330. The electron beam 330, the sample electron beam 332, and the reference electron beam 334 may be any electron beams appropriate for low energy electron microscopy (LEEM), such as an electron beam which produces a broad and parallel 1-100 eV electron beam. The electron beam 330, the sample electron beam 332, and the reference electron beam 334 may be a narrow (e.g., as used for traditional SEM) and coherent ~15 keV electron beams, which may be decelerated into a broad and parallel 1-100 eV electron beams by one or more immersion objective lens, such as immersion objective lenses 350 and 352. The electron beam 330, the sample electron beam 332, and the reference electron beam 334 may be decelerated or broadened, or accelerated or narrowed, such as by one or more lens 370A-370F, along path of the respective electron beams. The electron beam 330, the sample electron beam 332, and the reference electron beam 334 may be focused, shaped, etc., by one or more element along the paths of the respective electron beams, such as the lenses 370A-370F, magnetic prisms 372A and 372B, etc. The electrons of the electron beam 330, the sample electron beam 332, and the reference electron beam 334 may elastically scatter at one or more sample 360 or particle mirror 362, where the particle mirror may be an electrostatic mirror, a magnetic mirror, an electromagnetic mirror, etc. which causes electrons (or other particles) to reflect while maintaining coherence. The electron beam 330, the sample electron beam 332, and the reference electron beam 334 may interfere with each other, such as by recombination. The sample electron beam 332, and the reference electron beam 334 may be recombined such as by a beam combiner 344.

The sample electron beam 332 passes through a sample line 336, which includes the lenses 370A-370C, the magnetic prism 372A, the immersion objective lens 350, and the sample 360. The sample line 336 may include additional or fewer elements. The reference electron beam 334 passes through a reference line 338, which includes the lenses 370D-370F, the immersion objective lens 352, and the particle mirror 362. The reference line 338 may include additional or fewer elements, including elements such that it mimics or mirrors the sample line 336. The reference line 338 may include different components than the sample line 336 while maintaining coherence of the reference electron beam 334 with the sample electron beam 332.

The beam splitter 340 may be a biprism. The beam splitter 340 may be supplemented by an additional beam splitter 342, which may be a biprism. The beam combiner 344 may also be a biprism. The beam combiner 344 may be electromagnetic deflectors. The beam splitter 340, the additional beam splitter 342, and the beam combiner 344 may additionally or instead be elements which split, recombine, or redirect a portion of the electron beam 330, the sample electron beam 332, and the reference electron beam 334 while maintaining coherence. The magnetic prisms 37A and 37B may be other elements which alter a direction of the sample electron beam 332 of the reference electron beam 334 without reducing coherence. The sample 360 and the particle mirror 362 may additionally (or alternatively) be placed at a different position in the sample line 336 and the reference line 338, respectively, such that more or fewer magnetic prisms are placed within the sample line 336 and the reference line 338.

The sample electron beam 332 and the reference electron beam 334 may have the same coherence characteristics, and be coherent, at least along a part of their path lengths, with one another. The sample electron beam 332 may illuminate the sample 360, which may be supported by a sample holder (not show). The sample electron beam 332 is coherent over the extent of the sample (or the portion of the sample within the sample electron beam 332 path. The sample electron beam 332 has a transverse coherence length given by Equation 1, below:

$$L_\perp = \frac{\lambda}{2\pi\sigma_\theta} = \frac{\hbar}{mc}\frac{\sigma_x}{\epsilon_{N,x}} \qquad (1)$$

where $L_\perp$ is the transverse coherence length, $\lambda$ is the electron wavelength, $\sigma_\theta$ is a measure of angular spread, $\sigma_x$ is a measure of transverse spread (which may be 5 $\mu$m), and $\epsilon_{N,x}$ is a measure of electric field stability (which may be 3 pm rad for a Schottky FEG at 1 nA). The transverse coherence may then be calculated as approximately 644 nm, which gives a measurement spot size larger than 20 nm pitches, and which may therefore be useful for measurement of multiple 3D devices, trenches, etc. The number of fringes (such as interference fringes caused by recombination of the sample electron beam 332 and the reference electron beam 334) resolvable in the transverse direction may be given by Equation 2, below as:

$$2n = \frac{L_\perp}{\lambda} \qquad (2)$$

Which, given the values above, may be $n{\sim}1651$. The sample electron beam 332 has a longitudinal coherence length given by Equation 3, below:

$$L_\parallel = 2\lambda \frac{E_0}{\Delta E} \qquad (3)$$

Which for $\Delta E$=0.25eV for a 1-100 eV LEEM beam, may be given by the values in Chart 1, below:

| $E_0$ (eV) | $\lambda$ (nm) | $L_\parallel$(nm) | $2n$ |
|---|---|---|---|
| 1 | 1.2 | 9.8 | 8 |
| 3 | 0.71 | 17 | 24 |
| 10 | 0.39 | 31 | 80 |
| 30 | 0.23 | 54 | 240 |
| 100 | 0.12 | 97 | 800 |

The number of fringes in the recombination (e.g., of the sample electron beam 332 and the reference electron beam 334) in the longitudinal direction may be given by Equation 4, below

$$2n = \frac{L_\parallel}{\lambda} \qquad (4)$$

Which is analogous to Equation 2, above, for the transverse direction, and where it is assumed that the $L_\parallel$ is greater than the diameter of the objective lens $d_{obj}$. If the depth of interrogation (e.g., a resist thickness) is approximately 10 nm, then an electron energy $E_0 \geq 10$ eV will allow imaging of the sample within the coherence length.

The path length difference between the sample electron beam 332 as it traverses the sample line 336 and the reference electron beam 334 as it traverses the reference line 338 is smaller than the longitudinal coherence length, such that coherence between the sample electron beam 332 and the reference electron beam 334 is maintained. The path length difference may be altered by a delay segment. The delay segment may lie in the sample line 336 or the reference line 338. The delay segment may include an element to adjust a position of the sample 360 or the particle mirror 362. The delay segment may include an element that measures the path length of the sample electron beam 332 or the reference electron beam 334 or a difference between the sample electron beam 332 and the reference electron beam 334. The sample 360 may be a wafer (or portion of a wafer), such as fabricated during IC construction, which may have one or more layer of unknown or variable thickness. The delay segment may adjust the path length of the sample line 336 or the reference line 338 such that the path length of the sample line 336, which includes interaction of the sample electron beam 332 with the sample 360, is equivalent to the path length of the reference line 338. The delay segment may adjust the path length of the sample line 336 in the direction 364 (or in a direction perpendicular to the direction 364). The delay segment may adjust the path length of the reference line 338 in the direction 366 (or in a direction perpendicular to the direction 366). The delay segment may allow adjustment of the path length of the sample line 336 or the reference line 338 for each sample, during measurement, iteratively, etc. The delay segment may allow adjustment of the path length of the sample line 336 or the reference line 338 based on a recombination of the sample electron beam 332 and the reference electron beam 334, such as based on the interference pattern of the recombination.

The sample electron beam 332 and the reference electron beam 334 are recombined by the beam combiner 344. The recombination of the sample electron beam 332 and the refence electron beam 334 is detected by an electron detector 380. The electron detector 380 may be any appropriate sensor, including a pixelated sensor, a pixelated image detector, a phosphorescent screen, etc. The electron detector 380 may be used additionally to the electron detector 306 of the electron beam source 320 or may replace the electron detector 306 of the electron beam source 320. The electron detector 380 may be substantially planar. The electron detector 380 may detect, as the recombination, interference of the sample electron beam 332 and the reference electron beam 334. The interference may include constructive and destructive interference, analogous to the interference detected during LEEM. The recombination may be reconstructed to determine amplitude, phase, or wavefront (e.g., waveform, waveform shape, etc.) characteristics of the sample electron beam 332 as reflected (or otherwise interacted) by the sample 360. The recombination may contain information about the surface materials (such as carried by back scattered electrons (BSEs)), surface profile, and other characteristics of the sample 360. The recombination or a reconstruction of the electron beam 332 as reflected by the sample 360 may be used to detect defects in the sample, such as incomplete etching at the end of 3D trenches or holes. The recombination or the reconstruction of the sample electron beam 332 as reflected by the sample 360 may be used to determine critical dimension (CD) metrology, as it may be free from edge blooming, have no substantial interaction volume, reduce charging artifacts, reduce grid distortion, etc. The recombination or the reconstruction of the sample electron beam 332 as reflected by the sample 360 may be used to determine local 3D metrology, profilometry (e.g., floor tilt, side wall angle, roughness), etc. The recombination may be corrected using computational aberration corrections in order to improve resolution. The recombination or the reconstruction of the sample electron beam 332 as reflected by the sample 360 may have a field of view (FOV) of up to 6 $\mu$m and a resolution of up to 1 nm, which may be determined by the transverse and longitudinal coherence lengths.

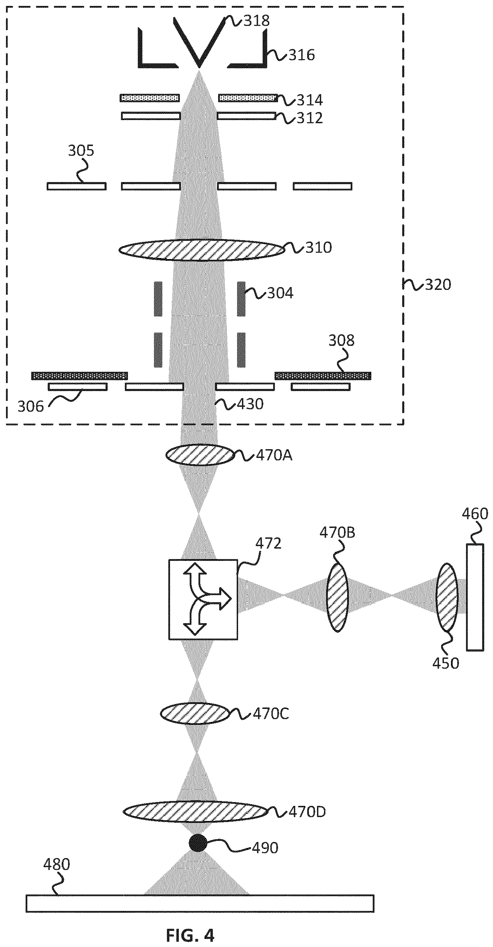

Figure 4 is a schematic diagram of an exemplary particle beam tool configured for holography based on a phase modulator. Figure 4 is a plan view of an exemplary particle beam apparatus, which will be described with reference to the electron beam source 320 of Figure 3, though it should be understood that the electron beam source 320 may be any appropriate electron beam source, such as that of the electron beam tool 140 of Figure 2. The electron beam source 320 has a cathode 318, an anode 316, a gun aperture 314, a beam limit aperture 312, a condenser lens 310, an objective lens 305, an objective lens assembly 304, an objective aperture 308, and an electron detector 306, as previously described.

The electron beam source 320 emits an electron beam 430, which is a coherent electron beam, such as previously described for the electron beam 330 of Figure 3. The electron beam 430 may be any electron beam appropriate for low energy electron microscopy (LEEM), such as an electron beam which produces a broad and parallel 1-100 eV electron beam. The electron beam 430 may be a narrow (e.g., as used for traditional SEM) and coherent ~15 keV electron beam, which may be decelerated into a broad and parallel 1-100 eV electron beams by one or more immersion objective lens 450. The electron beam 430 may be decelerated or broadened, or accelerated or narrowed, such as by one or more lens 430A-470D. The electron beam 430 may be focused, shaped, etc., by one or more element along the paths of the electron beam 430, such as the lenses 470A-479D, the immersion objective lens 450, magnetic prism 472, etc. The electrons of the electron beam 430 may elastically scatter at sample 460. The electron beam 430 may be modulated, such as by phase modulator 490. The phase modulator 490 may be a Zernike phase plate. The phase modulator 490 may diffract a portion of the electron beam 430, while leaving another portion of the electron beam 430 undiffracted. The phase modulator 490 modulate the electron beam 430 such a first portion of the electron beam 430 has a first phase and a second portion of the electron beam 430 has a second phase (e.g., after the electron beam 430 passes through the phase modulator 490). The phase modulator may be placed in any back focal plane (e.g., Fourier planes) of the electron beam 430, such as after it has interacted with the sample 460. The first portion of the electron beam 430 and the second portion of the electron beam 430 may recombine (e.g., interfere with each other, such as by constructive or destructive interference) and be detected by an electron detector 480. The first portion of the electron beam 430 and the second portion of the electron beam 430 may have the same coherence characteristics but different phases.

The recombination of the first portion of the electron beam 430 and the second portion of the electron beam 430 is detected by the electron detector 480, which may be used additionally to the electron detector 306 of the electron beam source 320 or may replace the electron detector 306 of the electron beam source 320. The electron detector 480 may be substantially planar. The electron detector 380 may detect, as the recombination, interference of the sample electron beam 332 and the reference electron beam 334. The interference may include constructive and destructive interference, analogous to the interference detected during phase contrast transmission electron microscopy (TEM). The recombination may be reconstructed to determine amplitude, phase, or wavefront characteristics of the electron beam 430 as reflected (or otherwise interacted) by the sample 460. The recombination may contain information about the surface materials (such as carried by back scattered electrons (BSEs)), surface profile, and other characteristics of the sample 460. The recombination or a reconstruction of the electron beam 430 as reflected by the sample 460 may be used to detect defects in the sample, such as incomplete etching at the end of 3D trenches or holes. The recombination or the reconstruction of the electron beam 430 as reflected by the sample 460 may be used to determine critical dimension (CD) metrology, as it may be free from edge blooming, have no substantial interaction volume, reduce charging artifacts, reduce grid distortion, etc. The recombination or the reconstruction of the electron beam 430 as reflected by the sample 460 may be used to determine local 3D metrology, profilometry (e.g., floor tilt, side wall angle, roughness), etc. The recombination may be corrected using computational aberration corrections in order to improve resolution.

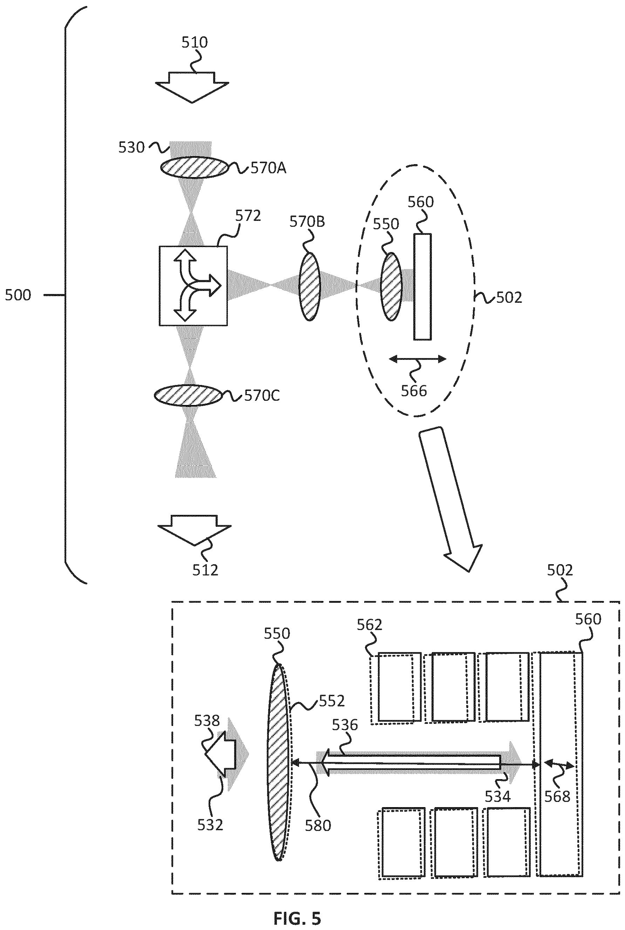

Figure 5 is a schematic diagram of an exemplary particle beam tool delay line. Figure 5 is a plan view of an exemplary delay line 500 containing an exemplary delay segment 502, which may be placed in a particle beam tool within an electron beam. The delay segment 502 may be used in the sample line 336 or the reference line 338 of Figure 3, with a path of the electron beam 430 of Figure 4, etc. The delay segment 502 may be used to alter a path length within an electron beam (or another particle beam) within any appropriate particle beam tool. The delay segment 502 may alter a path length of an electron beam within the delay segment 502 itself. The delay segment 502 may alter a path length of an electron beam external to the delay segment 502, such as by altering an angle of incident of an electron beam and thereby changing a path length of the electron beam inside or outside of extents of the delay segment 502. The path length may be altered by making it longer, such as longer by a small amount (e.g., on the order of an electron wavelength, 1 nm, etc.) or longer by a large amount (e.g., on the order of a sample thickness, 10 nm, 1 mm, up to on the order of a longitudinal coherence length), or by making it shorter, such as by a small amount or by a large amount. The path length may be altered by increasing a path length in one part and decreasing a path length in another part, such as by tilting of a reflector or lens. The path length may be altered by steps consistent with alignment, such as by adjustment of lens parameters, angles of reflection, positions in one or more directions, etc. The path length may be altered by altering an ancle of incidence, such that a path angle is altered. The path length may be altered by changing an angle of reflection or transmission medium, which may alter a transit time of the path length with or without altering a path length distance. The path length may be altered by changing a potential, such as an electrostatic potential distribution, inside one or more element of the delay segment 502. The path length may be altered in any appropriate manner where the path length is changed (or modified) without destroying coherence.

The delay line 500 receives an electron beam 530 from an input direction 510 and provides the electron beam to an output direction 512. The delay line 500 may also or instead receive the electron beam 530 (or an additional electron beam) from the output direction 512 and provide the electron beam 530 (or an additional electron beam) to the input direction 510. The electron beam 530 may be a coherent electron beam during at least some portions of the operation of the delay line 500. The electron beam 530 may be an incoherent electron beam during some portions of the operation of the delay line 500, such as during tuning, set up, during operations other than holography, etc.

The electron beam 530 may be any electron beam appropriate for low energy electron microscopy (LEEM), such as an electron beam which produces a broad and parallel 1-100 eV electron beam. The electron beam 530 may be a narrow (e.g., as used for traditional SEM) and coherent ~15 keV electron beam, which may be decelerated into a broad and parallel 1-100 eV electron beams by immersion objective lens 550. The electron beam 530 may be decelerated or broadened, or accelerated or narrowed, such as by one or more lens 530A-530C. The electron beam 530 may be focused, shaped, etc., by one or more element along the paths of the electron beam 530, such as the lenses 570A-570C, the immersion objective lens 550, magnetic prism 572, etc. The electrons of the electron beam 530 may elastically scatter at scatterer 560, which may be a sample, a particle mirror, a point scatterer, etc. The scatterer 560 may be adjusted, such as by altering the position along the direction 566, to change a path length (or time) of the delay line 500. The electron beam 530 may be output to a phase modulator, such as via the output direction 512, as previously described in reference to Figure 4. The electron beam 530 may be recombined (or otherwise interfered with another electron beam), such as via the output direction 512, as previously described in reference to Figure 3. The electron beam 530 may comprise multiple electron beams, such as having different phases, different energies, operating in different directions, etc. The delay line 500 may output the electron beam 530, such as in the output direction 512, to one or more electron detector. The delay line 500 may output the electron beam 530 to additional path segments, such as to interact with an additional scatterer (e.g., a sample, particle mirror, point scatterer, etc.).

The delay segment 502 may be made up of the immersion objective lens 550 and the scatterer 560. The delay segment 502 may be placed in any appropriate location in the delay line 500 or another line, such as the sample line 336 or the reference line 338 of Figure 3, a path of the electron beam 430 of Figure 4, etc. The scatterer 560 may be a sample, such as the sample 360 of the Figure 3, a particle mirror, a point scatterer, etc. The delay segment 502 may contain the immersion objective lens 550 or may receive input from any appropriate lens or electron beam source. For example, the delay segment 502 may be comprised of the scatterer 560 at a distance from another lens in the delay line 500. The delay segment 502 may receive an input electron beam 532, which may be the electron beam 530. The input electron beam 532 may transit the immersion objective lens 550 to become an input electron beam 532 which may transit a distance 580 between the immersion objective lens 550 and the scatterer 560. The input electron beam 532 or any portion thereof may then be reflected, scattered, or otherwise returned from the scatterer 560 as the output electron beam 536. The output electron beam 536 may transit the distance 580 to the immersion objective lens 550, which may emit a corresponding output electron beam 538.

A position of the scatterer 560 may be adjustable. The position of the scatterer may be adjustable by use of piezoelectric or other actuators. The position of the scatterer may be adjusted along an axis of an electron beam, such as along the axis of the input electron beam 534 or the output electron beam 536. The input electron beam 534 and the output electron beam 536 may be coaxial. The adjustment of the position of the scatterer 560 may increase or decrease the distance 580. The increase or decrease of the distance 580 may result in a corresponding increase or decrease of the path length of an electron beam which makes up the input electron beam 534 and the output electron beam 536. The adjustment of the position of the scatterer 560 may occur in another direction, such as from the position depicted for the scatterer 560 to the position depicted for a scatterer 562, such as along a vector 568. The adjustment of the position of the scatter 560 may be included in one or more alignment step, such as of the electron beam.

A strength or other parameter of the scatterer 560 may be adjustable. For example, voltages which make up a particle mirror may be adjusted. The parameters of the scatter 560 may be adjusted to change a path length within the scatterer 560-such as to change a transit path length within the scatterer 560. The parameters of the scatterer 560 may be adjusted to change an electron speed, angle of reflectance, etc. within the scatterer 560, which may change an effective path length of transit path within the scatterer 560. Any appropriate adjustment to the position or other parameters (e.g., various voltages, electrode separation distances, angle of orientation, etc.) may be made to the scatterer 560 to change a path length of the electron beam.

A position or other parameters of the immersion objective lens 550 may be adjustable. The immersion objective lens 550 may be adjusted in response to adjustments of the scatter 560. For example, the immersion objective lens 550 may be adjusted in focus, voltage, position, etc. to correspond to an adjusted immersion objective lens 552 when the scatterer 560 is adjusted to the position of the scatterer 562. The immersion objective lens 550 may be adjusted in order to compensate for the adjustment of the scatterer 560 while maintaining focus of the electron beam 530. The immersion objective lens 550 may be adjusted independently of the adjustment of the scatterer 560 in order to increase or decrease a path length of the electron beam 540 (for example, the distance 580). The immersion objective lens 550 may be adjusted in position by the same or different actuators that adjust a position of the scatterer 560. The immersion objective lens 550 may operate at a fixed distance to another object in the delay line 500, such as the magnetic prism 572, or may move in position in concert with the scatterer 560, including at a fractional distance where the immersion objective lens 550 moves a distance of x/r for each distance x moved by the scatterer 560.

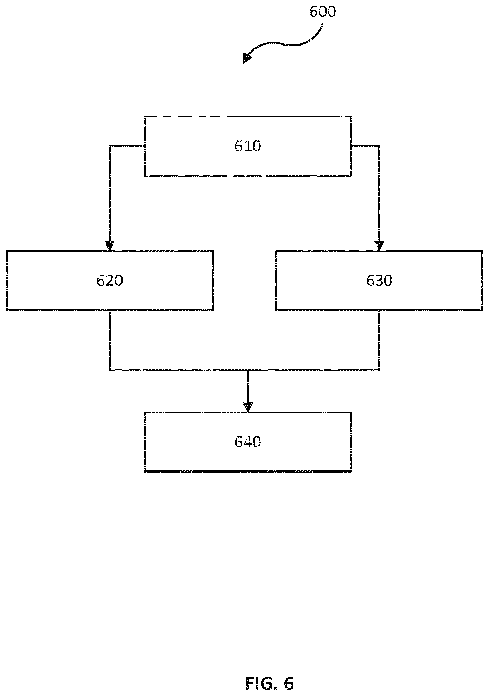

Figure 6 is a flowchart that illustrates a method of particle beam holography. Each of these operations is described in detail below. The operations of method 600 presented below are intended to be illustrative. In some embodiments, method 600 may be accomplished with one or more additional operations not described, and/or without one or more of the operations discussed. Additionally, the order in which the operations of method 600 are illustrated in Figure 6 and described below is not intended to be limiting. In some embodiments, one or more portions of method 600 may be implemented (e.g., by simulation, modeling, etc.) in one or more processing devices (e.g., one or more processors). The one or more processing devices may include one or more devices executing some or all of the operations of method 600 in response to instructions stored electronically on an electronic storage medium. The one or more processing devices may include one or more devices configured through hardware, firmware, and/or software to be specifically designed for execution of one or more of the operations of method 600, for example.

At an operation 610, a particle beam is split into a first particle beam and a second particle beam. The particle beam may be an electron beam. The first particle beam and the second particle beam are coherent along at least a portion of their path lengths. The first particle beam and the second particle beam may be split by a beam splitter, which may be a biprism. The first particle beam and the second particle beam may instead be phase modulated, such that the first particle beam corresponds to a first portion of the particle beam with a first phase and the second particle beam corresponds to a second portion the particle beam with a second phase different from the first phase. The phase modulator may preserve a phase, such that the first phase may be the phase of the particle beam and the second phase may be different than the phase of the particle beam or vice versa. The phase modulator may be a Zernike phase plate.

At an operation 620, the first particle beam is transmitted along a reference line. The reference line may include one or more particle transmission elements, such as lenses, prisms, mirrors, segment lines, etc.

At an operation 630, the second particle beam is transmitted along a sample line. The sample line may include one or more particle transmission elements, such as lenses, prisms, mirrors, delay segment, etc. The sample line includes interaction of the second particle beam with a sample.

The transmission of the first particle beam along the reference line and the transmission of the second particle beam along the sample line may occur substantially simultaneously, such as in parallel. The transmission of the first particle beam along the reference line and the transmission of the second particle beam along the sample line may start and stop at different times, while remaining substantially simultaneous. For example, the transmission along the sample line may begin before the transmission along the reference line, such as if the reference line includes a delay segment which may be adjusted or if the sample line is used for acquisition of an image prior to acquisition of holographic information. Transmission along the reference line or the transmission line does not require that either particle beam transit the entirety of the reference line or the transmission line, such as during alignment.

The first particle beam or the second particle beam includes a delay segment configured to alter a path length of the first particle beam of the second particle beam. The delay segment may include a particle mirror or a sample (e.g., sample holder) which may be positionally adjusted, such as on the order of the electron wavelength, the sample thickness, a coherence length, etc. to increase or decrease a path length of at least one of the sample line or the reference line. Transmitting of either the first particle beam or the second particle beam may include adjusting a path length of either particle beam to correspond to a path length of the other particle beam.

In one embodiment, the particle beam may be transmitted along the sample line, such that the particle beam interacts with the sample. After the particle beam interacts with the sample, the operation 610 may be performed, where the particle beam is split (e.g., modulated) to create the first particle beam, being a first portion of the particle beam with a first phase, and the second particle beam, being a second portion of the particle beam with a second phase.

At an operation 640, the first particle beam and the second particle beam are recombined. The first particle beam and the second particle beam may cause interference between the first particle beam and the second particle beam. The recombination may be detected by a particle detector. The recombination may include application of an aberration correction to the recombination. The recombination may include determination of an aberration correction to be applied to the recombination. The recombination may be used to determine a phase or amplitude of the first particle beam after it has interacted with the sample. The recombination may be used to determine a depth profile of the sample. The recombination may be used to determine a 3D image of the sample.

In one embodiment, recombining the first particle beam and the second particle beam may be recombing a first portion of the particle beam with a first phase and a second portion of the particle beam with a second phase.

As described above, method 600 (and/or the other methods and systems described herein) is configured for particle beam holography.

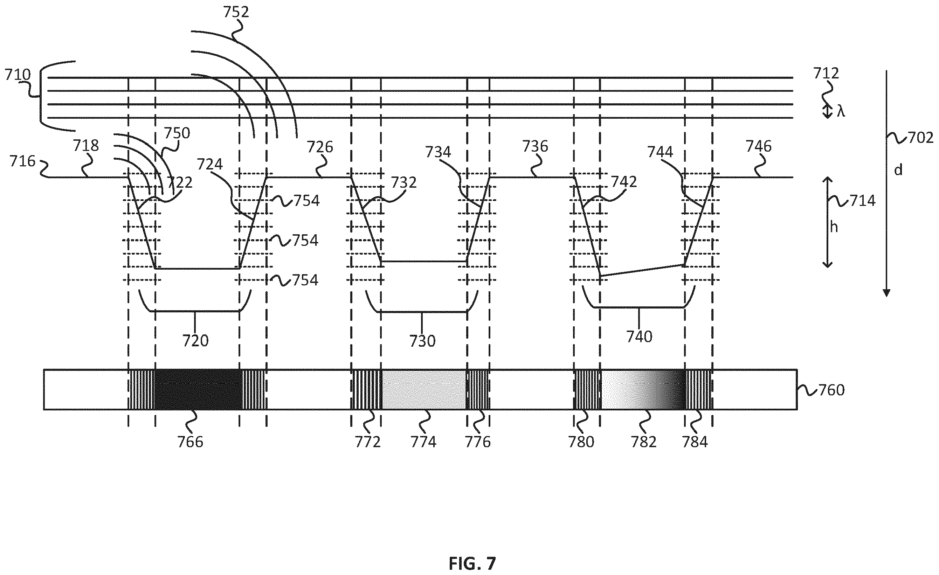

Figure 7 is a schematic diagram of an exemplary recombination of a first particle beam and a second particle beam. Figure 7 is a cross-sectional view of an electron wavefront 710 incident on a surface 716 with and a corresponding phase contrast image 760. The phase contrast image 760 may be a hologram image of the surface 716, and may be used to reconstruct information about the surface 716, the electron wavefront 710 as it reflects of the surface 716, etc.

The electron wavefront 710 is a wavefront corresponding to a low energy (where low energy is relative and herein corresponds to energies at which electrons backscatter elastically (e.g., coherently)) electron beam. The electron wavefront 710 is broad, with a large (relatively large, e.g., larger than on the scale of the features of the surface 716), diffuse peak such that the electron wavefront 710 is roughly parallel to a longitudinal axis of the surface 716. The electron wavefront 710 approaches the surface along a direction d 702, which is roughly parallel to depth in the surface 716 and such that multiple peaks of the electron beam creating the electron wavefront 710 are coherent, parallel, etc. This direction is selected for ease of description, but it should be understood that the electron wavefront 710 may instead impinge on the surface 716 with a perpendicular angle of arrival, either intentionally (for example, such as parallel to a sidewall angle) or unintentionally (such as due to sample defects, drift, etc.). The electron wavefront 710 has an electron wavelength $\lambda$ 712, which may be on the order of 1 nm.

The surface 716 has a surface profile represented in cross section by the line containing segments 718, 726, 736, and 746, which correspond to raised plateaus of the sample, segments 720, 730, and 740, which correspond to trenches of the sample, and segments 722, 724, 732, 734, 742, and 744, which correspond to sidewalls of the sample. The surface profile has a height h 714 of approximately 10 nm, where the height h 714 is the difference between the depth of the plateaus of segments 718, 726, 736, and 746 and the trenches of segments 720, 730, and 740. The surface profile is provided as an example, where other surface profiles may be interrogated.

When the electron wavefront 710 reaches the surface 716, it is elastically (e.g., coherently) scattered by the surface (as shown in scattering event 750). The electron wavefront 710 incident on the surface 716 is scattered which creates a reflected electron wavefront 752 which radiates outwards from the sample. The reflected electron wavefront 752 contains information about the change in depth of the surface 716. For example, the electron wavefront 710 incident on the plateau of the segment 726 and the electron wavefront 710 incident on the trench of the segment 720 travel different distances (e.g., on both the journey to the sample and the journey away from the sample), corresponding to electron wavefronts 754. The reflected electron wavefront 752 may also contain information about the material of the sample, such as encoded in the intensity of BSE electrons.

The reflected electron wavefront 752 may then be recombined with a reference electron wavefront which has not reflected off the sample, and which is coherent with the electron wavefront 710. The recombination between the reflected electron wavefront 752 and the reference electron wavefront may generate a recombination which may be measured as an interference pattern at an electron detector, such as by the corresponding phase contrast image 760.

The phase contrast image 760 corresponds to the intensity of the interference pattern caused by the recombination of the reflected electron wavefront 752 and the reference electron wavefront. The difference in intensity of phase contrast image 760 is shown as binary (e.g., black or white) pattern for ease of depiction, but-depending on resolution-is a sinusoidal pattern (e.g., in intensity) displaying grayscale values as well. The phase contrast image 760, based on the relative phase contrast of surfaces (for example the trench of the segment 720 with contrast 766 and the trench of the segment 730 with contrast 774) contains information about whether surfaces are in-plane or offset along the direction d 702. The phase contrast image 760, based on the number of fringes, also contains information about the rate of depth change (or slope) or surfaces. For example, the sidewall of the segment 732 is sloped less steeply than the sidewall of the segment 734 but is approximately as deep, and correspondingly a larger wavelength is displayed in the interference fringe 772 that in that of interference fringe 776 but both the interference fringe 772 and the interference fringe 776 have the same number of maximums and minimums in intensity. In another example, the sidewall of the segment 742 and the sidewall of the segment 744 have substantially the same width but different depths, where the sidewall of the segment 742 has a steeper slope than the sidewall of the segment 744. Correspondingly, interference fringe 780 has an additional number of interference fringes (e.g., 1 as depicted corresponding to the difference in depth between the sidewall of the segment 742 and the sidewall of the segment 744 which is approximately equal to the electron wavelength λ 712 as depicted) when compared to interference fringe 784. The interference fringe 780 and the interference fringe 784 occupy roughly the same lateral extent in the phase contrast image 760, corresponding to the substantially similar widths of the sidewall of the segment 742 and the sidewall of the segment 744, which leads the interference fringe 780 to have a smaller wavelength than the interference fringe 784. The phase contrast image 760, based on the presence or absence of fringes, contains information about the relative flatness of features. For example, the trench of segment 740 is angled relative to the direction d 702, which appears as a corresponding gradient in the contrast 782.

The phase contrast image 760 or other signals corresponding to the recombination of the reflected electron wavefront 752 (e.g., the sample electron beam) and the reference electron wavefront (e.g., the reference electron beam) may be used, based on these and other principles, to reconstruct information about the surface 716.

In one embodiment, the reflected electron wavefront 752 may be phase modulated instead of recombined with a reference electron wavefront, such as through the use of a Zernike phase plate. The reflected electron wavefront 752 may be used to produce a first portion of an electron beam having a first phase and a second portion of the electron beam having a second phase. The first phase or the second phase may be a phase shift from the phase of the electron beam before modulation. Either the first phase or the second phase may be the phase of the electron beam before modulation (e.g., a negligible phase shift). The first portion of the electron beam (e.g., of the reflected electron wavefront 752) and the second portion of the electron beam (e.g., of the reflected electron wavefront 752) may then be recombined with each other through interference. The recombination may generate a phase contrast image, such as the phase contrast image 760.

An image of the recombination, which is a digital hologram, may be used to acquire information about both the phase and amplitude of the reflected electron wavefront 752. For example, an intensity of the image may be given by Equation 5, below:

$$I = |E_0|^2 + |E_r|^2 + 2|E_0||E_r|\cos(\varphi_0 - kx) \qquad (5)$$

Where $E_0$ is the electron wavefront corresponding to the reflection from the sample, $E_r$ is the reference electron wavefront, $|E_0|$ is the amplitude of the reflection from the sample, $\varphi_0$ is the phase of the reflection from the sample, x is the displacement, and k is the wavenumber. The recombination may be processed, such as by a fast Fourier transform (FFT) or other appropriate transform, to generate information about both the phase and amplitude of the reflection from the sample (e.g., $|E_0||E_r|\exp(j\varphi_0)$).

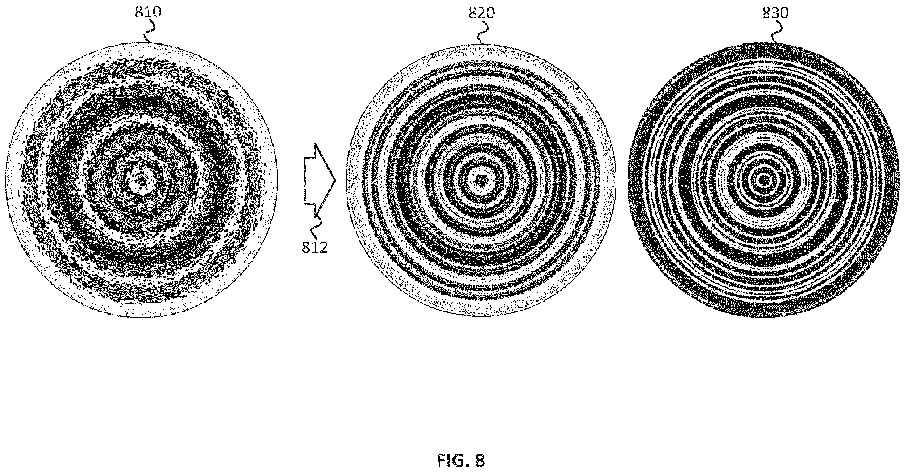

Figure 8 is a schematic diagram of an exemplary aberration correction. Figure 8 is a view of an example digital hologram 810 as well as aberration corrections 820 and 830. If the immersion lenses of the example particle beam are magnetic immersion lenses, spherical or chromatic aberrations can be corrected using aberration corrections determined by holographic reconstruction. An example digital hologram 810 may be acquired for a sample which is a null sample. A null sample may be a known sample, such as a particle reflector, point scatterer, absence of a sample, etc. The digital hologram 810 may be subjected to a transform 812, such as an FFT, and averaged over multiple data acquisitions to determine an average of the aberration corrections 820 and 830 in amplitude and phase. The aberration corrections 820 and 830 can then be transformed back into the intensity space and applied to data acquired for samples in order to correct for lens aberrations.

The hologram (e.g., the recombination of the first particle beam and the second particle beam or of the first portion of the particle beam with a first phase and the second portion of the particle beam with the second phase) may be related to the object wave (e.g., the reflected electron wavefront 752 of Figure 7, the reflection from the sample $E_0$, etc.) by the relationship given by Equation 6, below:

$$hologram = I = |R + O|^2 = |R|^2 + |O|^2 + R^*O + RO^* \qquad (6)$$

Where R represents the reference wave (e.g., the reference electron wavefront as described in Figure 7, the reference electron wave $E_r$, etc.) and O represents the object wave. The reconstruction of the object wave may be determined by a multiplication of the reference wave and the hologram, such as by using Equation 7, below:

$$reconstruction = RI = R|R|^2 + R|O|^2 + |R|^2 O + RRO^* \qquad (7)$$

Where the object wave can be determined from the $|R|^2 O$ term.

Aberration correction can account for imperfections in the lenses or reference wave. By choosing the object wave to be equal to the reference wave (for example, by replacing a sample with a point scatterer, particle mirror, etc.), the reference wave itself may be reconstructed. For example, the hologram of the reference wave with itself is governed by Equation 8, below

$$I = |R + R|^2 = 4|R|^2 \qquad (6)$$

Which may be used to determine a difference between the measured intensity I and the reference wave R and therefore determine a mathematical correction to the measured intensity I to account for aberration in one or more lens.

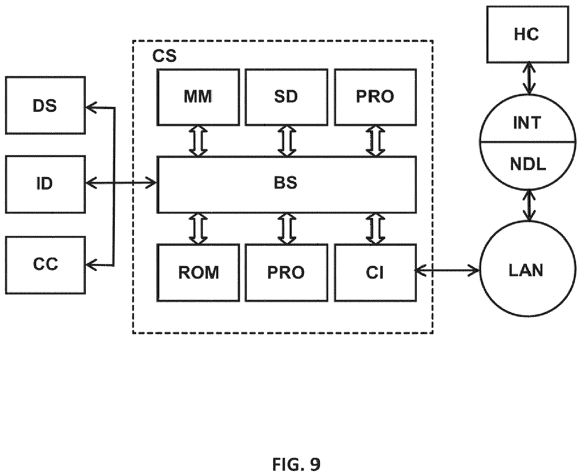

Figure 9 is a diagram of an example computer system CS that may be used for one or more of the operations described herein. Computer system CS includes a bus BS or other communication mechanism for communicating information, and a processor PRO (or multiple processors) coupled with bus BS for processing information. Computer system CS also includes a main memory MM, such as a random-access memory (RAM) or other dynamic storage device, coupled to bus BS for storing information and instructions to be executed by processor PRO. Main memory MM also may be used for storing temporary variables or other intermediate information during execution of instructions by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a cathode ray tube (CRT) or flat panel or touch panel display for displaying information to a computer user. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

In some embodiments, portions of one or more methods described herein may be performed by computer system CS in response to processor PRO executing one or more sequences of one or more instructions contained in main memory MM. Such instructions may be read into main memory MM from another computer-readable medium, such as storage device SD. Execution of the sequences of instructions included in main memory MM causes processor PRO to perform the process steps (operations) described herein. One or more processors in a multi-processing arrangement may also be employed to execute the sequences of instructions contained in main memory MM. In some embodiments, hard-wired circuitry may be used in place of or in combination with software instructions. Thus, the description herein is not limited to any specific combination of hardware circuitry and software.

The term "computer-readable medium" and/or "machine readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or light waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have instructions recorded thereon. The instructions, when executed by a computer, can implement any of the operations described herein. Transitory computer-readable media can include a carrier wave or other propagating electromagnetic signal, for example.

Various forms of computer readable media may be involved in carrying one or more sequences of one or more instructions to processor PRO for execution. For example, the instructions may initially be borne on a magnetic disk of a remote computer. The remote computer can load the instructions into its dynamic memory and send the instructions over a telephone line using a modem. A modem local to computer system CS can receive the data on the telephone line and use an infrared transmitter to convert the data to an infrared signal. An infrared detector coupled to bus BS can receive the data carried in the infrared signal and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic, or optical signals that carry digital data streams representing various types of information.

Network link NDL typically provides data communication through one or more networks to other data devices. For example, network link NDL may provide a connection through local network LAN to a host computer HC. This can include data communication services provided through the worldwide packet data communication network, now commonly referred to as the "Internet" INT. Local network LAN (Internet) may use electrical, electromagnetic, or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN, and communication interface CI. One such downloaded application may provide all or part of a method described herein, for example. The received code may be executed by processor PRO as it is received, and/or stored in storage device SD, or other non-volatile storage for later execution. In this manner, computer system CS may obtain application code in the form of a carrier wave.

Embodiments of the disclosure are defined in the following numbered clauses:

Clause 1: a particle beam system comprising:

a beam splitter configured to split a particle beam into a first particle beam and a second particle beam, the first particle beam and the second particle beam being coherent along at least a portion of their path lengths;
a reference line configured to enable transmission of the first particle beam;
a sample line configured to enable the second particle beam to interact with a sample;
a delay segment configured to alter a path length of the first particle beam in the reference line and/or to alter a path length of the second particle beam in the sample line; and
a beam combiner configured to recombine a) the first particle beam after it passes through the reference line, and b) the second particle beam after it passes through the sample line, wherein the recombination of the first particle beam and the second particle beam causes interference between the first particle beam and the second particle beam.

Clause 2: the particle beam system of clause 1, wherein the sample line comprises a low-energy electron microscopy (LEEM) arrangement.
Clause 3: the particle beam system of clause 1 or 2, wherein the second particle beam is elastically scattered by the sample.
Clause 4: the particle beam system of any of the previous clauses, wherein the delay segment comprises a particle mirror.
Clause 5: the particle beam system of clause 4, wherein the particle mirror is an electrostatic and/or magnetic mirror.
Clause 6: the particle beam system of any of the previous clauses, wherein the sample line comprises an immersion objective lens.
Clause 7: the particle beam system of any of the previous clauses, wherein the sample line and/or the reference line comprises a magnetic prism.
Clause 8: the particle beam system of any of the previous clauses, further comprising a sensor to detect the recombination, the sensor configured to detect intensity of the interference between the first particle beam and the second particle beam.
Clause 9: the particle beam system of clause 8, wherein the sensor is a pixelated particle detector.
Clause 10: the particle beam system of any of the previous clauses, further comprising:

a processor; and

one or more non-transitory, machine-readable medium having instructions thereon, the instructions when executed by the processor being configured to:

determine phase and/or amplitude of a waveform of the first particle beam after it has interacted with the sample based on the interference between the first particle beam and the second particle beam.

Clause 11: the particle beam system of clause 10, wherein the instructions further comprise instructions to: reconstruct a depth profile of the sample based on the determined phase and/or amplitude of the waveform of the first particle beam after it has interacted with the sample.

Clause 12: the particle beam system of clause 10 or 11, wherein the instructions further comprise instructions to: apply an aberration correction to the determined phase and/or amplitude of the waveform of the first particle beam after it has interacted with the sample.

Clause 13: the particle beam system of clause 12, wherein the instructions further comprise instructions to determine an aberration correction.

Clause 14: the particle beam system of clause 13, wherein instructions to determine an aberration correction comprise instructions to determine an aberration correction based on a recombination of the first particle beam and the second particle beam obtained when the second particle beam has not interacted with a sample and/or when the particle beam has interacted with a known sample.

Clause 15: the particle beam system of clause 14, wherein the known sample is a point-scatterer.

Clause 16: the particle beam system of any of the previous clauses, the delay segment further configured to alter the path length of the first particle beam and/or to alter the path length of the second particle beam such that the first particle beam and the second particle beam interfere at their recombination.

Clause 17: the particle beam system of any of the previous clauses, wherein the particle beam is a coherent, low-energy electron beam.

Clause 18: the particle beam system of any of the previous clauses, wherein the interference comprises constructive and/or destructive interference.

Clause 19: the particle beam system of any of the previous clauses, wherein the beam splitter is a biprism and/or wherein the beam combiner is a biprism.

Clause 20: the particle beam system of any of the previous clauses, wherein the beam combiner comprises electromagnetic deflectors.

Clause 21: a delay line for a particle beam system, wherein the delay line is configured to alter a path length of at least a portion of a particle beam of the particle beam system.

Clause 22: the delay line of clause 21, wherein the delay line comprises a particle mirror and wherein the particle mirror is an electrostatic and/or magnetic mirror.

Clause 23: a particle beam system comprising:

a sample line configured to enable a particle beam to interact with a sample;

a phase modulator configured to output a first portion of the particle beam with a first phase and a second portion of the particle beam with a second phase; and

a sensor being configured to detect a recombination of the first portion and the second portion of the particle beam.

Clause 24: the particle beam system of clause 23, wherein the recombination of the first portion and the second portion of the particle beam comprises interference of the first portion of the particle beam and the second portion of the particle beam.

Clause 25: the particle beam system of clause 23 or 24, wherein the phase modulator comprises a Zernike phase plate and wherein the first portion of the particle beam comprise a diffracted portion of the particle beam and wherein the second portion of the particle beam comprises an undiffracted portion of the particle beam.

Clause 26: a method of particle beam microscopy comprising:

splitting, by a beam splitter, a particle beam into a first particle beam and a second particle beam, the first particle beam and the second particle beam being coherent along at least a portion of their path lengths;

transmitting the first particle beam along a reference line;

transmitting a second particle beam along a sample line, the sample line configured to enable interaction of the second particle beam with a sample,

wherein the reference line and/or the sample line further comprise a delay segment, the delay segment configured to alter a path length of the first particle beam and/or to alter a path length of the second particle beam; and

recombining, by a beam combiner, a) the first particle beam after it passes through the reference line and b) the second particle beam after it passes through the sample line, wherein the recombination of the first particle beam and the second particle beam causes interference between the first particle beam and the second particle beam.

Clause 27: the method of clause 26, wherein transmitting the first particle beam further comprises adjusting the path length of the first particle beam to correspond to the path length of the second particle beam.

Clause 28: the method of clause 26 or 27, wherein transmitting the second particle beam further comprises adjusting the path length of the second particle beam to correspond to the path length of the first particle beam.

Clause 29: the method of any of the clauses 26 to 28, further comprising applying an aberration correction to the recombination.

Clause 30: the method of clause 29, further comprising determining the aberration correction, wherein determining the aberration correction comprises:

transmitting the first particle beam along the reference line, the delay segment configured to alter the path length of the first particle beam to correspond to the path length of the second particle beam and/or to alter the path length of the second particle beam to correspond to the path length of the first particle beam;

transmitting a second particle beam along the sample line, the sample line configured to enable reflection of the second particle beam from a null sample and/or a known sample;

recombining, by the beam combiner, a) the first particle beam after it passes through the reference line and b) the second particle beam after it has been reflected by the null sample and/or after it has been reflected by the known sample to generate an aberration-correction recombination; and

determining an aberration correction based on the aberration-correction recombination.

Clause 31: the method of any of the clauses 26 to 30, further comprising determining phase and/or amplitude of a waveform of the first particle beam after it has interacted with the sample based on the recombination.

Clause 32: the method of any of the clauses 26 to 31, further comprising reconstructing a depth profile of the sample based on the recombination.

While the concepts disclosed herein may be used for manufacturing with a substrate such as a silicon wafer, it shall be understood that the disclosed concepts may be used with any type of manufacturing system (e.g., those used for manufacturing on substrates other than silicon wafers).

In addition, the combination and sub-combinations of disclosed elements may comprise separate embodiments. For example, one or more of the operations described above may be included in separate embodiments, or they may be included together in the same embodiment.

The descriptions above are intended to be illustrative, not limiting. Thus, it will be apparent to one skilled in the art that modifications may be made as described without departing from the scope of the claims set out below.

**Claims**

1. A particle beam system comprising:

a beam splitter configured to split a particle beam into a first particle beam and a second particle beam, the first particle beam and the second particle beam being coherent along at least a portion of their path lengths;

a reference line configured to enable transmission of the first particle beam;

a sample line configured to enable the second particle beam to interact with a sample;

a delay segment configured to alter a path length of the first particle beam in the reference line and/or to alter a path length of the second particle beam in the sample line; and

a beam combiner configured to recombine a) the first particle beam after it passes through the reference line, and b) the second particle beam after it passes through the sample line, wherein the recombination of the first particle beam and the second particle beam causes interference between the first particle beam and the second particle beam.

2. The particle beam system of claim 1, wherein the sample line comprises a low-energy electron microscopy (LEEM) arrangement.

3. The particle beam system of claim 1, wherein the second particle beam is elastically scattered by the sample.

4. The particle beam system of claim 1, wherein the delay segment comprises a particle mirror.

5. The particle beam system of claim 4, wherein the particle mirror is an electrostatic and/or magnetic mirror.

6. The particle beam system of claim 1, wherein the sample line and/or the reference line comprises a magnetic prism.

7. The particle beam system of claim 1, further comprising a sensor to detect the recombination, the sensor configured to detect intensity of the interference between the first particle beam and the second particle beam.

8. The particle beam system of claim 7, wherein the sensor is a pixelated particle detector.

9. The particle beam system of claim 1, further comprising:

   a processor; and
   one or more non-transitory, machine-readable medium having instructions thereon, the instructions when executed by the processor being configured to:
   determine phase and/or amplitude of a waveform of the first particle beam after it has interacted with the sample based on the interference between the first particle beam and the second particle beam.

10. The particle beam system of claim 9, wherein the instructions further comprise instructions to:
    reconstruct a depth profile of the sample based on the determined phase and/or amplitude of the waveform of the first particle beam after it has interacted with the sample.

11. The particle beam system of claim 9, wherein the instructions further comprise instructions to:
    apply an aberration correction to the determined phase and/or amplitude of the waveform of the first particle beam after it has interacted with the sample.

12. The particle beam system of claim 11, wherein the instructions further comprise instructions to determine the aberration correction.

13. The particle beam system of claim 1, the delay segment further configured to alter the path length of the first particle beam and/or to alter the path length of the second particle beam such that the first particle beam and the second particle beam interfere at their recombination.

14. The particle beam system of claim 1, wherein the particle beam is a coherent, low-energy electron beam.

15. A method of particle beam microscopy comprising:

    splitting, by a beam splitter, a particle beam into a first particle beam and a second particle beam, the first particle beam and the second particle beam being coherent along at least a portion of their path lengths;
    transmitting the first particle beam along a reference line;
    transmitting a second particle beam along a sample line, the sample line configured to enable interaction of the second particle beam with a sample, wherein the reference line and/or the sample line further comprise a delay segment, the delay segment configured to alter a path length of the first particle beam and/or to alter a path length of the second particle beam; and
    recombining, by a beam combiner, a) the first particle beam after it passes through the reference line and b) the second particle beam after it passes through the sample line, wherein the recombination of the first particle beam and the second particle beam causes interference between the first particle beam and the second particle beam.

100

130a

130b

130

120

140

110

150

**FIG. 1**

FIG. 2

EP 4 411 783 A1

**FIG. 3**

FIG. 4

FIG. 5

600

610

620    630

640

FIG. 6

**FIG. 7**

EP 4 411 783 A1

FIG. 8

FIG. 9

Europäisches
Patentamt

European
Patent Office

Office européen
des brevets

# EUROPEAN SEARCH REPORT

**Application Number**

EP 23 15 4317

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/124850 A1 (MATSUMOTO TAKAO [JP] ET AL) 15 June 2006 (2006-06-15) * abstract * * paragraphs [0002], [0032] – [0062]; claims 1,2,10; figures 1,3,4,6 * | 1,2,7-9, 13-15 | INV. H01J37/28 G03H5/00 |
| A | US 2015/076350 A1 (PLETTNER THOMAS [US] ET AL) 19 March 2015 (2015-03-19) * abstract * * figures 5,9A * | 1 | |
| A | ROBERT M. GLAESER: "Invited Review Article: Methods for imaging weak-phase objects in electron microscopy", REVIEW OF SCIENTIFIC INSTRUMENTS, vol. 84, no. 11, 2013, page 111101, XP055175360, ISSN: 0034-6748, DOI: 10.1063/1.4830355 * abstract * * pages 11101-3 – pages 11101-15; table 1 * | 1 | |
| | | | **TECHNICAL FIELDS SEARCHED (IPC)** |
| X | US 4 998 788 A (OSAKABE NOBUYUKI [JP] ET AL) 12 March 1991 (1991-03-12) * abstract * * column 1, lines 6-12 * * column 1, line 36 – column 4, line 49; claim 1; figures 2,4 * | 1-3,7,8, 13-15 | H01J G03H |

The present search report has been drawn up for all claims

| Place of search | Date of completion of the search | Examiner |
|---|---|---|
| Munich | 30 September 2023 | Lang, Thomas |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

...........................................................................
& : member of the same patent family, corresponding
  document

EPO FORM 1503 03.82 (P04C01)

Europäisches
Patentamt

European
Patent Office

Office européen
des brevets

Application Number

EP 23 15 4317

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☒ Only part of the further search fees have been paid within the fixed time limit. The present European search report has been drawn up for those parts of the European patent application which relate to the inventions in respect of which search fees have been paid, namely claims:

1-3, 7-9, 13-15

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 23 15 4317

The Search Division considers that the present European patent application does not comply with the requirements of unity of invention and relates to several inventions or groups of inventions, namely:

1. claims: 1, 2, 7-9, 13-15

   A particle beam system comprising: a beam splitter configured to split a particle beam into a first particle beam and a second particle beam, the first particle beam and the second particle beam being coherent along at least a portion of their path lengths; a reference line configured to enable transmission of the first particle beam; a sample line configured to enable the second particle beam to interact with a sample; a delay segment configured to alter a path length of the first particle beam in the reference line and/or to alter a path length of the second particle beam in the sample line; and a beam combiner configured to recombine a) the first particle beam after it passes through the reference line, and b) the second particle beam after it passes through the sample line, wherein the recombination of the first particle beam and the second particle beam causes interference between the first particle beam and the second particle beam (claim 1),
   wherein the sample line comprises a low-energy electron microscopy arrangement (claim 2).
   ---

2. claim: 3

   The particle beam system of claim 1, wherein the second particle beam is elastically scattered by the sample.
   ---

3. claims: 4, 5

   The particle beam system of claim 1, wherein the delay segment comprises a particle mirror.
   ---

4. claim: 6

   The particle beam system of claim 1, wherein the sample line and/or the reference line comprises a magnetic prism.
   ---

5. claim: 10

   The particle beam system of claim 9, wherein the instructions further comprise instructions to reconstruct a depth profile of the sample based on the determined phase and/or amplitude of the waveform of the first particle beam after it has interacted with the sample.
   ---

6. claims: 11, 12

page 1 of 2

Europäisches
Patentamt

European
Patent Office

Office européen
des brevets

**LACK OF UNITY OF INVENTION
SHEET B**

**Application Number**

**EP 23 15 4317**

The Search Division considers that the present European patent application does not comply with the requirements of unity of invention and relates to several inventions or groups of inventions, namely:

The particle beam system of claim 1, further comprising a processor; and one or more non-transitory, machine-readable medium having instructions thereon, the instructions when executed by the processor being configured to determine phase and/or amplitude of a waveform of the first particle beam after it has interacted with the sample based on the interference between the first particle beam and the second particle beam (claim 9), wherein the instructions further comprise instructions to apply an aberration correction to the determined phase and/or amplitude of the waveform of the first particle beam after it has interacted with the sample (claims 11-12).

---

**page 2 of 2**

30

## ANNEX TO THE EUROPEAN SEARCH REPORT
## ON EUROPEAN PATENT APPLICATION NO.

EP 23 15 4317

This annex lists the patent family members relating to the patent documents cited in the above-mentioned European search report.
The members are as contained in the European Patent Office EDP file on
The European Patent Office is in no way liable for these particulars which are merely given for the purpose of information.

30-09-2023

| Patent document cited in search report | | Publication date | Patent family member(s) | | Publication date |
|---|---|---|---|---|---|
| US 2006124850 | A1 | 15-06-2006 | JP | 2006164861 A | 22-06-2006 |
| | | | US | 2006124850 A1 | 15-06-2006 |
| US 2015076350 | A1 | 19-03-2015 | EP | 3047502 A1 | 27-07-2016 |
| | | | JP | 6527872 B2 | 05-06-2019 |
| | | | JP | 6713067 B2 | 24-06-2020 |
| | | | JP | 2016534536 A | 04-11-2016 |
| | | | JP | 2019061970 A | 18-04-2019 |
| | | | TW | 201519257 A | 16-05-2015 |
| | | | US | 2015076350 A1 | 19-03-2015 |
| | | | WO | 2015042051 A1 | 26-03-2015 |
| US 4998788 | A | 12-03-1991 | DE | 69031765 T2 | 02-07-1998 |
| | | | EP | 0378237 A2 | 18-07-1990 |
| | | | JP | 2776862 B2 | 16-07-1998 |
| | | | JP | H02186547 A | 20-07-1990 |
| | | | US | 4998788 A | 12-03-1991 |

EPO FORM P0459

For more details about this annex : see Official Journal of the European Patent Office, No. 12/82